# EUROPEAN PATENT APPLICATION

(11) **EP 4 255 159 A1**
(43) Date of publication of application: **04.10.2023**
(21) Application number: 23161265.6
(22) Date of filing: 10.03.2023
(51) Int. Cl.: H10N 30/076, B06B 1/06, H10N 30/00, H10N 30/853, H10N 30/87

(54) **PIEZOELECTRIC-BODY FILM JOINT SUBSTRATE AND MANUFACTURING METHOD THEREOF**

(30) Priority: 30.03.2022 JP 2022055448
(71) Applicant: Oki Electric Industry Co., Ltd., Minato-ku Tokyo 105-8460 (JP)
(72) Inventor: FURUTA, Hironori, Tokyo, 105-8460 (JP); KOSAKA, Toru, Tokyo, 105-8460 (JP); SUZUKI, Takahito, Tokyo, 105-8460 (JP); TANIGAWA, Kenichi, Tokyo, 105-8460 (JP); ISHIKAWA, Takuma, Tokyo, 105-8460 (JP); KITAJIMA, Yutaka, Tokyo, 105-8460 (JP)
(74) Representative: Betten & Resch

(57) **Abstract**

A piezoelectric-body film joint substrate (100) includes a substrate (33); a first electrode (34a), a first piezoelectric-body film (17) stuck on the first electrode (34a) and including a first piezoelectric film (15) and a first upper electrode film (16) formed on the first piezoelectric film (15), a second electrode (34b), and a second piezoelectric-body film (27) stuck on the second electrode (34b) and including a second piezoelectric film (25) different from the first piezoelectric film (15) and a second upper electrode film (26) formed on the second piezoelectric film (25). A height from an upper surface of the substrate (33), on which the first electrode (34a) and the second electrode (34b) are formed, to a top of the first upper electrode film (16) and a height from the upper surface of the substrate (33) to a top of the second upper electrode film (26) differ from each other.

## Description

### BACKGROUND OF THE INVENTION

### 1. Field of the Invention

The present disclosure relates to a piezoelectric-body film joint substrate and a manufacturing method thereof.

### 2. Description of the Related Art

Conventionally, there has been disclosed an ultrasonic sensor as a piezoelectric film integrated device configured by forming polycrystalline piezoelectric films of different types on the same substrate. See Japanese Patent Application Publication No. 2021-166220 (Patent Reference 1), for example.

However, a high-performance device including a plurality of piezoelectric films cannot be obtained when a plurality of piezoelectric films of different types are formed on the same substrate.

### SUMMARY OF THE INVENTION

An object of the present disclosure is to provide a high-performance piezoelectric-body film joint substrate in which piezoelectric films of two or more types are provided on the same substrate and a manufacturing method thereof.

A piezoelectric-body film joint substrate according to an aspect of the present disclosure includes: a substrate, a first electrode provided on the substrate, a first piezoelectric-body film stuck on the first electrode and including a first piezoelectric film and a first upper electrode film formed on the first piezoelectric film, a second electrode provided on the substrate; and a second piezoelectric-body film stuck on the second electrode and including a second piezoelectric film different from the first piezoelectric film and a second upper electrode film formed on the second piezoelectric film. A height from an upper surface of the substrate, on which the first electrode and the second electrode are formed, to a top of the first upper electrode film and a height from the upper surface of the substrate to a top of the second upper electrode film differ from each other.

A method of manufacturing a piezoelectric-body film joint substrate in the present disclosure is a method of manufacturing a piezoelectric-body film joint substrate including a device substrate and a first piezoelectric-body film and a second piezoelectric-body film different from each other in film thickness. The manufacturing method includes peeling off the first piezoelectric-body film formed on a first substrate and the second piezoelectric-body film formed on a second substrate respectively from the first substrate and the second substrate, sticking a film with first film thickness on a first electrode formed on the device substrate when one of the first piezoelectric-body film and the second piezoelectric-body film, having less film thickness, is defined as the film with the first film thickness and the other one of the first piezoelectric-body film and the second piezoelectric-body film, having greater film thickness, is defined as a film with second film thickness, and sticking the film with the second film thickness on a second electrode formed on the device substrate after the sticking of the film with the first film thickness.

Another method of manufacturing a piezoelectric-body film joint substrate in the present disclosure is a method of manufacturing a piezoelectric-body film joint substrate including a device substrate having a first electrode and a second electrode different from each other in film thickness, a first piezoelectric-body film, and a second piezoelectric-body film. The manufacturing method includes peeling off the first piezoelectric-body film formed on a first substrate and the second piezoelectric-body film formed on a second substrate respectively from the first substrate and the second substrate, sticking the second piezoelectric-body film on an electrode with second film thickness formed on the device substrate when one of the first electrode and the second electrode, having greater film thickness, is defined as an electrode with first film thickness and the other one of the first electrode and the second electrode, having less film thickness, is defined as the electrode with the second film thickness, and sticking the first piezoelectric-body film on the first electrode after the sticking of the film with the second film thickness.

According to the present disclosure, it is possible to provide a high-performance piezoelectric-body film joint substrate in which piezoelectric films of two or more types are provided on the same substrate and a manufacturing method thereof.

### BRIEF DESCRIPTION OF THE DRAWINGS

The present disclosure will become more fully understood from the detailed description given hereinbelow and the accompanying drawings which are given by way of illustration only, and wherein:
Fig. 1 is a side view schematically showing the structure of a piezoelectric-body film joint substrate according to a first embodiment;
Fig. 2 is a top view schematically showing the structure of the piezoelectric-body film joint substrate in Fig. 1;
Fig. 3 is a cross-sectional view of the piezoelectric-body film joint substrate in Fig. 2 taken along the line S3-S3;
Fig. 4 is a flowchart showing a method of manufacturing the piezoelectric-body film joint substrate according to the first embodiment;
Figs. 5A and 5B are a top view and a cross-sectional view schematically showing the structure of a PZT epitaxial growth film in step ST101 in Fig. 4, and Figs. 5C and 5D are a top view and a cross-sectional view schematically showing the structure of a plurality of PZT piezoelectric-body films in step ST102 in Fig. 4;
Figs. 6A and 6B are a top view and a cross-sectional view schematically showing the structure of an AlN epitaxial growth film in step ST104 in Fig. 4, and Figs. 6C and 6D are a top view and a cross-sectional view schematically showing the structure of a plurality of AlN piezoelectric-body films in step ST105 in Fig. 4;
Figs. 7A and 7B are cross-sectional views schematically showing a holding process of a plurality of PZT piezoelectric-body films in step ST103 in Fig. 4;
Figs. 8A and 8B are cross-sectional views schematically showing a holding process of a plurality of AlN piezoelectric-body films in step ST106 in Fig. 4;
Fig. 9A is a cross-sectional view schematically showing a sticking process of the AlN piezoelectric-body film in step ST107 in Fig. 4, and Fig. 9B is a top view showing a state in which the AlN piezoelectric-body film has been stuck;
Fig. 10A is a cross-sectional view schematically showing a sticking process of the PZT piezoelectric-body film in step ST108 in Fig. 4, and Fig. 10B is a top view showing a state in which the PZT piezoelectric-body film has been stuck;
Fig. 11A is a cross-sectional view schematically showing a sticking process of another PZT piezoelectric-body film in step ST108 in Fig. 4, and Fig. 11B is a top view showing a state in which the PZT piezoelectric-body film has been stuck;
Figs. 12A and 12B are a side view and a top view schematically showing the structure of a piezoelectric-body film joint substrate according to a modification of the first embodiment;
Figs. 13A and 13B are a top view and a cross-sectional view schematically showing the structure of an AlN piezoelectric-body film according to the modification of the first embodiment, and Figs. 13C and 13D are a top view and a cross-sectional view schematically showing the structure of a PZT piezoelectric-body film;
Figs. 14A and 14B are a side view and a top view schematically showing the structure of a piezoelectric-body film joint substrate according to a second embodiment;
Fig. 15 is a flowchart showing a method of manufacturing the piezoelectric-body film joint substrate according to the second embodiment;
Fig. 16 is a cross-sectional view schematically showing the structure of an epitaxial growth film including the PZT piezoelectric-body film;
Fig. 17 is a cross-sectional view schematically showing the structure of an epitaxial growth film including the AlN piezoelectric-body film;
Fig. 18A is a cross-sectional view schematically showing a sticking process of the AlN piezoelectric-body film in step ST207 in Fig. 15, and Fig. 18B is a top view showing a state in which the AlN piezoelectric-body film has been stuck;
Fig. 19A is a cross-sectional view schematically showing a sticking process of the PZT piezoelectric-body film in step ST208 in Fig. 15, and Fig. 19B is a top view showing a state in which the PZT piezoelectric-body film has been stuck;
Fig. 20A is a cross-sectional view schematically showing a sticking process of another PZT piezoelectric-body film, and Fig. 20B is a top view showing a state in which the PZT piezoelectric-body film has been stuck;
Figs. 21A and 21B are a side view and a top view schematically showing the structure of a piezoelectric-body film joint substrate according to a third embodiment;
Fig. 22 is a flowchart showing a method of manufacturing the piezoelectric-body film joint substrate according to the third embodiment;
Fig. 23 is a cross-sectional view schematically showing the structure of an epitaxial growth film including a PZT piezoelectric-body film;
Fig. 24 is a cross-sectional view schematically showing the structure of an epitaxial growth film including an AlN piezoelectric-body film;
Figs. 25A and 25B are a top view and a cross-sectional view schematically showing the structure of the PZT piezoelectric-body film in step ST301 in Fig. 22, and Figs. 25C and 25D are a top view and a cross-sectional view schematically showing the structure of the PZT piezoelectric-body film in step ST302 in Fig. 22;
Figs. 26A and 26B are a top view and a cross-sectional view schematically showing the structure of the AlN piezoelectric-body film in step ST304 in Fig. 22, and Figs. 26C and 26D are a top view and a cross-sectional view schematically showing the structure of the AlN piezoelectric-body film in step ST305 in Fig. 22;
Figs. 27A and 27B are cross-sectional views schematically showing a holding process of a plurality of PZT piezoelectric-body films in step ST303 in Fig. 22;
Figs. 28A and 28B are cross-sectional views schematically showing a holding process of a plurality of AlN piezoelectric-body films in step ST306 in Fig. 22;
Fig. 29A is a cross-sectional view schematically showing a sticking process of the AlN piezoelectric-body film in step ST307 in Fig. 22, and Fig. 29B is a top view showing a state in which the AlN piezoelectric-body film has been stuck;
Fig. 30A is a cross-sectional view schematically showing a sticking process of the PZT piezoelectric-body film in step ST308 in Fig. 22, and Fig. 30B is a top view showing a state in which the PZT piezoelectric-body film has been stuck; and
Fig. 31A is a cross-sectional view schematically showing a sticking process of another PZT piezoelectric-body film in step ST308 in Fig. 22, and Fig. 31B is a top view showing a state in which the PZT piezoelectric-body film has been stuck.

### DETAILED DESCRIPTION OF THE INVENTION

A piezoelectric-body film joint substrate and a manufacturing method thereof according to each embodiment will be described below with reference to the drawings. The following embodiments are just examples and a variety of modifications are possible within the scope of the present disclosure. In the present application, the piezoelectric-body film joint substrate is a product as an intermediate in which a plurality of piezoelectric films are provided on the same substrate. While the piezoelectric films are desired to be monocrystalline piezoelectric films, it is also possible to form the piezoelectric-body film joint substrate with polycrystalline piezoelectric films.

By using a piezoelectric-body film joint substrate according to each embodiment, a piezoelectric film integrated device including a plurality of piezoelectric bodies can be manufactured. The piezoelectric film integrated device is an acoustic oscillation sensor, for example. Incidentally, the acoustic oscillation sensor is a sensor that detects status (e.g., distance, shape, movement or the like) of a detection target object by outputting an acoustic oscillatory wave and detecting reflected waves of the acoustic oscillatory wave. The acoustic oscillation sensor is referred to also as an "ultrasonic sensor". In general, and in the present application, the acoustic oscillatory wave is made up of at least one of a sonic wave and an ultrasonic wave. Namely, the acoustic oscillatory wave includes a sonic wave, an ultrasonic wave, or both of a sonic wave and an ultrasonic wave.

### (1) First Embodiment

### (1-1) Structure of Piezoelectric-Body Film Joint Substrate 100

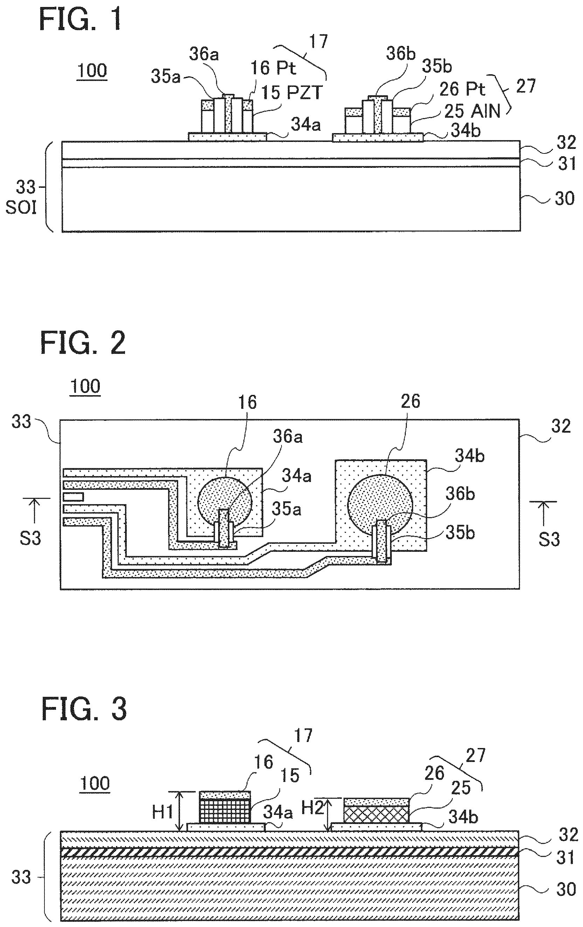

Fig. 1 is a side view schematically showing the structure of a piezoelectric-body film joint substrate 100 according to a first embodiment. Fig. 2 is a top view schematically showing the structure of the piezoelectric-body film joint substrate 100. Fig. 3 is a cross-sectional view of the piezoelectric-body film joint substrate 100 in Fig. 2 taken along the line S3-S3.

The piezoelectric-body film joint substrate 100 includes an SOI substrate 33 as a substrate and platinum (Pt) films 34a and 34b as electrodes (i.e., substrate electrodes) provided on the SOI substrate 33. As shown in Fig. 2, the Pt films 34a and 34b are connected to a wiring layer formed on the SOI substrate 33. The SOI stands for Silicon On Insulator. Further, in the SOI substrate 33, there may be formed a drive circuit for driving the piezoelectric-body film joint substrate 100 and thereby generating the acoustic oscillatory wave, a processing circuit that executes a process by using an acoustic oscillatory wave detection signal, and so forth.

The piezoelectric-body film joint substrate 100 includes the Pt film 34a as a first electrode (substrate electrode) provided on the SOI substrate 33, a PZT piezoelectric-body film 17 as a first piezoelectric-body film stuck on the Pt film 34a, the Pt film 34b as a second electrode (substrate electrode) provided on the SOI substrate 33, and an AlN piezoelectric-body film 27 as a second piezoelectric-body film stuck on the Pt film 34b. The PZT piezoelectric-body film 17 includes a PZT film 15 as a first piezoelectric film and a Pt film 16 as a first upper electrode film formed on the PZT film 15, and is stuck on the Pt film 34a. The AlN piezoelectric-body film 27 includes an AlN film 25 as a second piezoelectric film different from the first piezoelectric film (e.g., in crystal structure) and a Pt film 26 as a second upper electrode film formed on the AlN film 25, and is stuck on the Pt film 34b. In the first embodiment, a height from an upper surface of the SOI substrate 33, on which the Pt film 34a and the Pt film 34b are formed, to the top of the Pt film 16 (H1 in Fig. 3) and a height from the upper surface of the SOI substrate 33 to the top of the Pt film 26 (H2 in Fig. 3) differ from each other. In the first embodiment, a relationship H1 > H2 is satisfied.

The AlN represents aluminum nitride. The PZT represents piezoelectric zirconate titanate (lead zirconate titanate). As the second piezoelectric-body film, instead of the AlN piezoelectric-body film, a different piezoelectric film such as a lithium tantalate (LiTaO₃) piezoelectric-body film or a lithium niobate (LiNbO₃) piezoelectric-body film may be used. As the first piezoelectric-body film, instead of the PZT piezoelectric-body film, a different piezoelectric-body film such as a potassium sodium niobate (KNN) piezoelectric-body film or a barium titanate (BaTiO₃) piezoelectric-body film may be used. Further, while the first and second piezoelectric-body films are desired to be monocrystalline piezoelectric-body films, polycrystalline piezoelectric-body films may also be used. In the illustrated example, the PZT piezoelectric-body film 17 is a piezoelectric body that generates the acoustic oscillatory wave, and is desired to be a piezoelectric body having a higher piezoelectric constant and capable of obtaining greater oscillation amplitude compared to the AlN piezoelectric-body film 27. The AlN piezoelectric-body film 27 is a piezoelectric body that detects the acoustic oscillatory wave (or its reflected waves), and is a piezoelectric body having lower specific inductive capacity and higher detection sensitivity compared to the PZT piezoelectric-body film 17.

Incidentally, it is also possible to use the AlN piezoelectric-body film 27 as the first piezoelectric-body film and use the PZT piezoelectric-body film 17 as the second piezoelectric-body film.

Further, as shown in Fig. 1, the piezoelectric-body film joint substrate 100 includes an insulation film 35a, a wiring film 36a formed on the insulation film 35a, an insulation film 35b, and a wiring film 36b formed on the insulation film 35b.

The SOI substrate 33 includes a Si substrate 30, a silicon dioxide (SiOz) part 31 as an insulation film, and a monocrystalline silicon (monocrystalline Si) part 32. Cavities (holes) may be formed by etching the Si substrate 30 in regions of the monocrystalline Si part 32 under the PZT film 15 and the AlN film 25 (i.e., regions respectively overlapping with the piezoelectric films). The SiO₂ part 31 and the monocrystalline Si part 32 situated in the regions where the cavities are formed have a function as a vibrating plate. Further, as the substrate, a substrate made of a different material such as a glass substrate or an organic film substrate may also be used instead of the SOI substrate 33. The acoustic oscillatory wave generated by the PZT film 15 is outputted through the cavity, and the AlN film 25 detects reflected waves of the acoustic oscillatory wave through the cavity.

The thickness of the PZT film 15 is generally in a range of 10 nm to 10 µm, and preferably in a range of 100 nm to 5 µm. The thickness of the AlN film 25 is generally in a range of 10 nm to 10 µm, and preferably in a range of 100 nm to 2 µm. The Pt films 34a and 34b are formed on the upper surface of the SOI substrate 33. The surface (upper surface) of the Pt film 34b and the AlN piezoelectric-body film 27 are joined together by intermolecular force. The surface of the Pt film 34a and the PZT piezoelectric-body film 17 are joined together by intermolecular force. For these joints, the use of an adhesive agent is unnecessary. For excellently joining these surfaces by intermolecular force, the surface roughness of a sticking surface of the AlN piezoelectric-body film 27, a sticking surface of the PZT piezoelectric-body film 17 and the Pt films 34a and 34b is desired to be less than or equal to 10 nm. For this purpose, a process for smoothing the surfaces of the Pt films 34a and 34b may be executed. Further, the surface roughness of interfaces when the sticking surface of the PZT piezoelectric-body film 17 and the sticking surface of the AlN piezoelectric-body film 27 have been stuck respectively on the Pt films 34a and 34b is less than or equal to 10 nm. Furthermore, area of the surface of the Pt film 34a is desired to be larger than area of the sticking surface of the PZT piezoelectric-body film 17, and area of the surface of the Pt film 34b is desired to be larger than area of the sticking surface of the AlN piezoelectric-body film 27. Thanks to such structure, a permissible range of a sticking accuracy error when the AlN piezoelectric-body film 27 and the PZT piezoelectric-body film 17 are stuck on the Pt films 34b and 34a can be made wide.

### (1-2) Manufacturing Method

In the manufacture of the piezoelectric-body film joint substrate 100, the PZT piezoelectric-body film 17 formed on a growth substrate 11 and including the PZT film 15 and the Pt film 16 formed on the PZT film 15 and the AlN piezoelectric-body film 27 formed on a growth substrate 21 and including the AlN film 25 and the Pt film 26 formed on the AlN film 25 are peeled off respectively from the growth substrates 11 and 21, and are respectively stuck on the Pt films 34a and 34b as electrodes formed on the SOI substrate 33 different from both of the growth substrates 11 and 21.

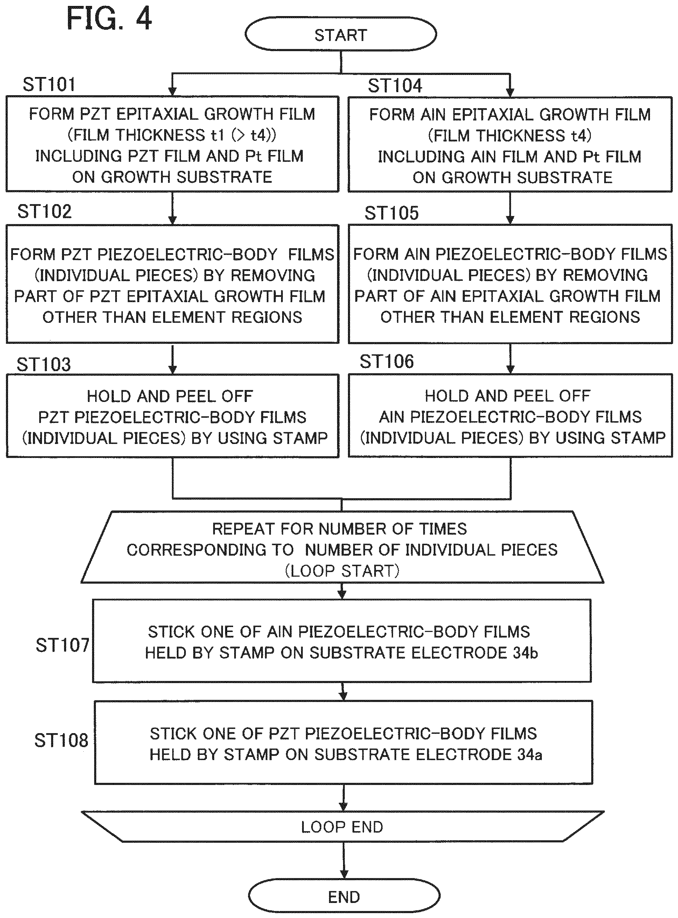

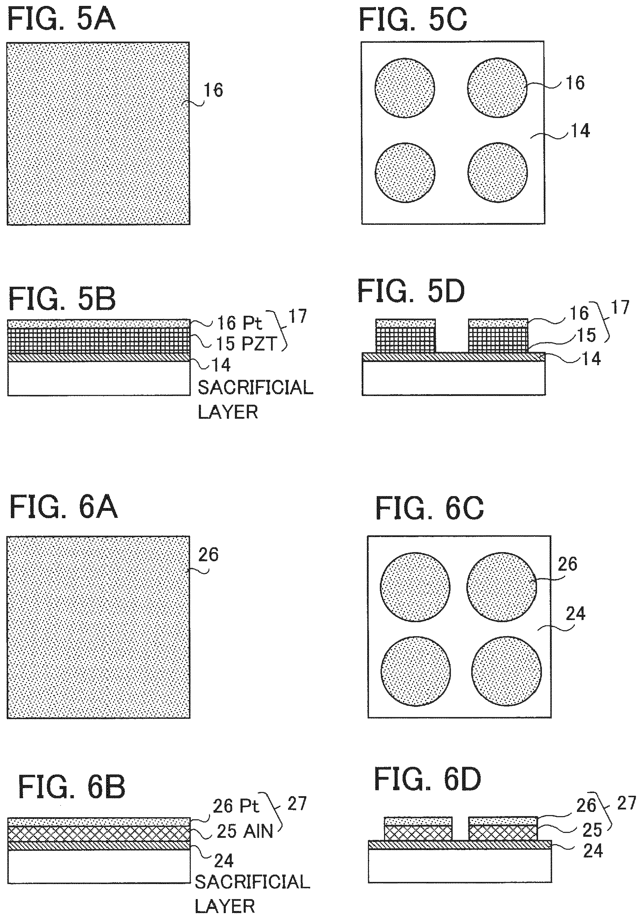

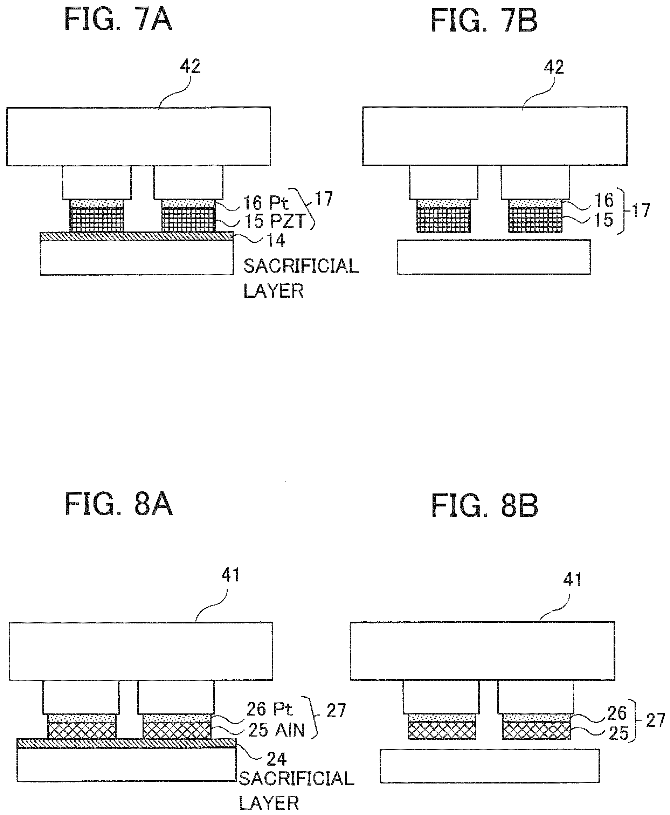

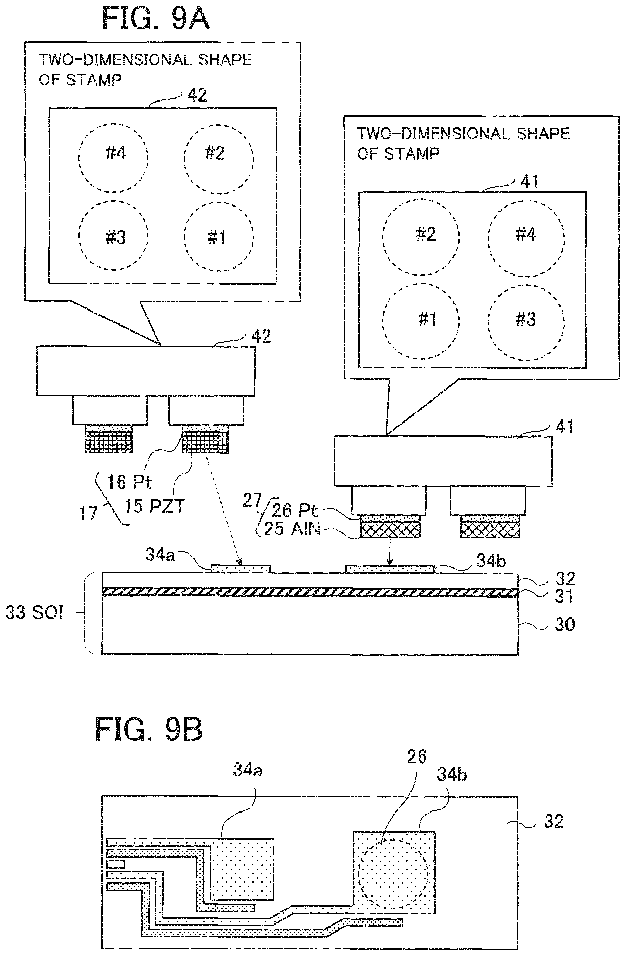

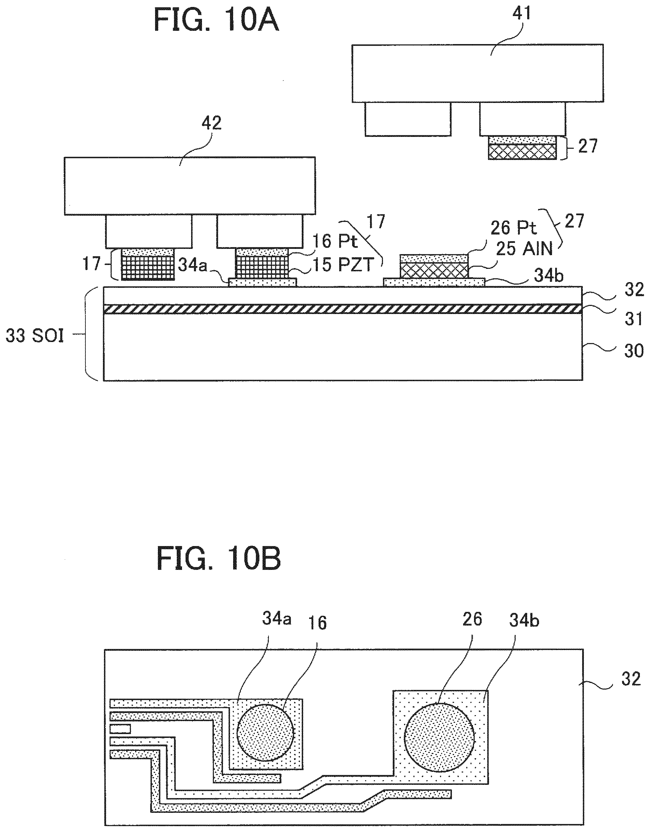

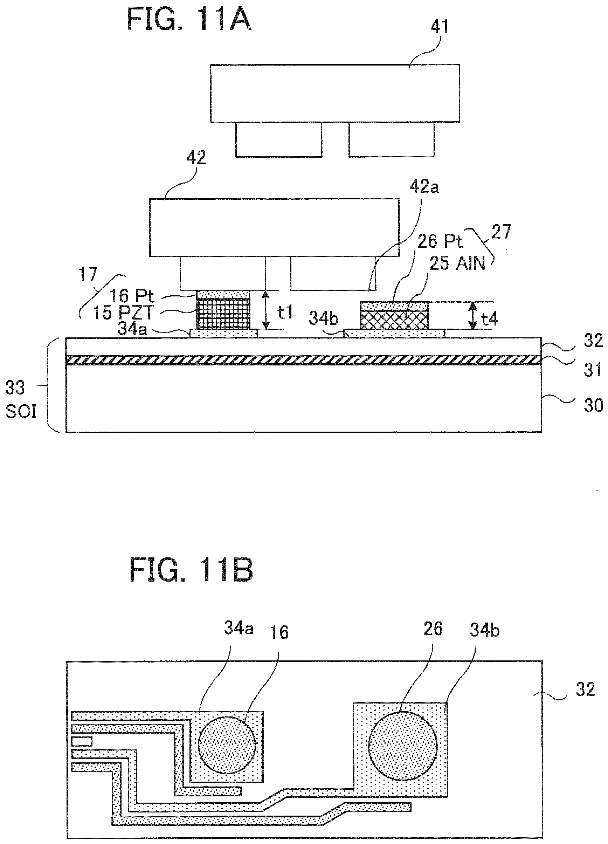

Fig. 4 is a flowchart showing a method of manufacturing the piezoelectric-body film joint substrate 100. Figs. 5A and 5B are a top view and a cross-sectional view schematically showing the structure of a PZT epitaxial growth film in step ST101 in Fig. 4. Figs. 5C and 5D are a top view and a cross-sectional view schematically showing the structure of the PZT epitaxial growth film in step ST102 in Fig. 4. Figs. 6A and 6B are a top view and a cross-sectional view schematically showing the structure of an AlN epitaxial growth film in step ST104 in Fig. 4. Figs. 6C and 6D are a top view and a cross-sectional view schematically showing the structure of the AlN epitaxial growth film in step ST105 in Fig. 4. Figs. 7A and 7B are cross-sectional views schematically showing a holding process of a plurality of PZT piezoelectric-body films 17 in step ST103 in Fig. 4. Figs. 8A and 8B are cross-sectional views schematically showing a holding process of a plurality of AlN piezoelectric-body films 27 in step ST106 in Fig. 4. Fig. 9A is a cross-sectional view schematically showing a sticking process of the AlN piezoelectric-body film 27 in step ST107 in Fig. 4, and Fig. 9B is a top view showing a state in which the AlN piezoelectric-body film 27 has been stuck. Fig. 10A is a cross-sectional view schematically showing a sticking process of the PZT piezoelectric-body film 17 in step ST108 in Fig. 4, and Fig. 10B is a top view showing a state in which the PZT piezoelectric-body film 17 has been stuck. Fig. 11A is a cross-sectional view showing a manufacturing process of the next piezoelectric-body film joint substrate, and Fig. 11B is a top view showing a state in which the PZT piezoelectric-body film 17 has been stuck.

First, a sacrificial layer 14, the PZT film 15 and the Pt film 16 are grown epitaxially on a growth substrate as shown in Figs. 5A and 5B (step ST101), and a plurality of PZT piezoelectric-body films 17 are formed by forming the PZT film 15 and the Pt film 16 into circular shapes by means of etching as shown in Figs. 5C and 5D (step ST102).

Further, a sacrificial layer 24, the AlN film 25 and the Pt film 26 are grown epitaxially on another growth substrate as shown in Figs. 6A and 6B (step ST104), and a plurality of AlN piezoelectric-body films 27 are formed by forming the AlN film 25 and the Pt film 26 into circular shapes by means of etching as shown in Figs. 6C and 6D (step ST105).

Subsequently, as shown in Figs. 7A and 7B, the plurality of (4 in the illustrated example) PZT piezoelectric-body films 17 as individual pieces each formed with the PZT film 15 and the Pt film 16 are held by a stamp 42 as a holding member and are peeled off by etching the sacrificial layer (step ST103). Further, as shown in Figs. 8A and 8B, the plurality of (4 in the illustrated example) AlN piezoelectric-body films 27 as individual pieces each formed with the AlN film 25 and the Pt film 26 are held by a stamp 41 as a holding member and are peeled off by etching the sacrificial layer (step ST106).

Subsequently, as shown in Figs. 9A and 9B, one of the plurality of AlN piezoelectric-body films 27 held by the stamp 41 is stuck on the Pt film 34b (step ST107).

Subsequently, as shown in Figs. 10A and 10B, one of the plurality of PZT piezoelectric-body films 17 held by the stamp 42 is stuck on the Pt film 34a (step ST108). It is also possible to add a process of strengthening the sticking of Pt and each piezoelectric film by performing an annealing process after the sticking.

As shown in Figs. 11A and 11B, in the first embodiment, contact electrodes and a wiring pattern are formed with Pt on the SOI substrate 33, the AlN piezoelectric-body film 27 is stuck on the Pt film 34b, and thereafter the PZT piezoelectric-body film 17 is stuck on the Pt film 34a. In cases where the AlN piezoelectric-body films 27 held by the stamp 41 are in a 2 x 2 matrix, the AlN piezoelectric-body films 27 are successively stuck on different SOI substrates 33 in the illustrated order of #1, #2, #3 and #4. In this example, four SOI substrates 33 are prepared for the four piezoelectric-body films. Subsequently, the PZT piezoelectric-body film 17 is stuck on the Pt film 34a as shown in Figs. 10A and 10B. In cases where the PZT piezoelectric-body films 17 held by the stamp 42 are in a 2 x 2 matrix, the PZT piezoelectric-body films 17 are successively stuck on different SOI substrates 33 in the illustrated order of #1, #2, #3 and #4. The sticking is executed successively as shown in Figs. 10A and 10B. In this case, since the height H2 of the top of the AlN piezoelectric-body film 27 is lower than the height H1 of the top of the PZT piezoelectric-body film 17, a part 42a of the stamp 42 never makes contact with the AlN piezoelectric-body film 27 stuck on the Pt film 34b as shown in Fig. 11A.

Subsequently, the insulation film 35a and the wiring film 36a are formed on the PZT film 15 and the Pt film 16, and the insulation film 35b and the wiring film 36b are formed on the AlN film 25 and the Pt film 26.

At the time of the sticking, the hexagonal crystal of AlN and the cubic crystal of PZT are arranged in a phase relationship so that their c-axes are parallel to each other, by which efficiency of the piezoelectric oscillation driving of the PZT film 15 and the piezoelectric oscillation reception of the AlN film 25 is maximized.

### (1-3) Modification

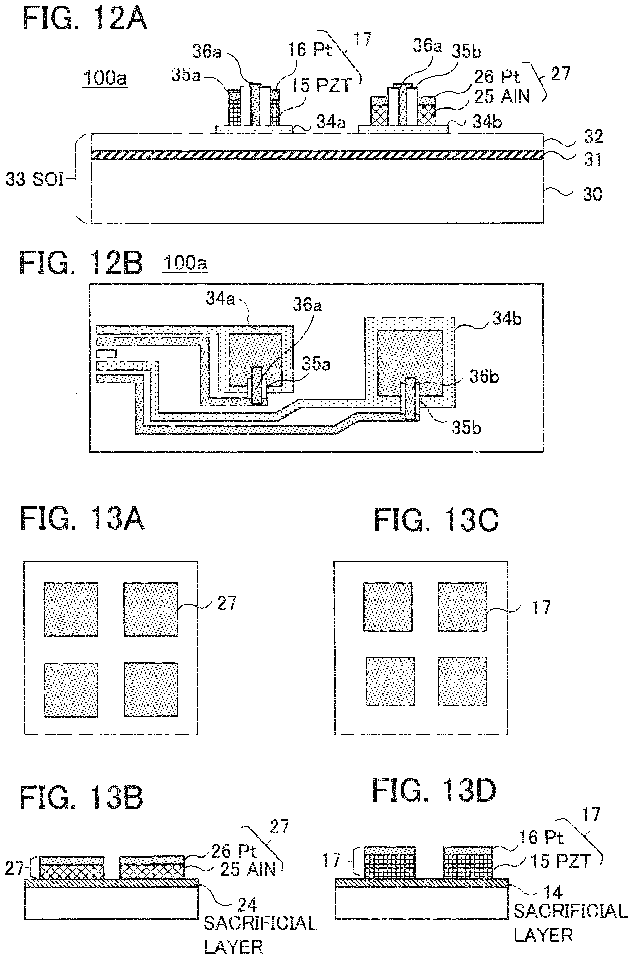

Figs. 12A and 12B are a side view and a top view schematically showing the structure of a piezoelectric-body film joint substrate 100a according to a modification of the first embodiment. Figs. 13A and 13B are a top view and a cross-sectional view schematically showing the structure of the AlN piezoelectric-body film 27, and Figs. 13C and 13D are a top view and a cross-sectional view schematically showing the structure of the PZT piezoelectric-body film 17. The piezoelectric-body film joint substrate 100a differs from the piezoelectric-body film joint substrate 100 shown in Fig. 1 to Fig. 3 in that the two-dimensional shape of each of the AlN piezoelectric-body film 27 and the PZT piezoelectric-body film 17 is a quadrangular shape. Except for this feature, the piezoelectric-body film joint substrate 100a is the same as the piezoelectric-body film joint substrate 100.

### (1-4) Effect

As described above, in the first embodiment, the PZT piezoelectric-body film 17 and the AlN piezoelectric-body film 27, which are unlikely to grow epitaxially on the same SOI substrate 33 because of the difference in the lattice constant and the crystal structure, are respectively formed on separate growth substrates, peeled off from the growth substrates, and stuck on a common SOI substrate 33 in superimposition, by which a high-performance piezoelectric-body film joint substrate 100 can be made. Further, by the sticking of the piezoelectric-body films on the substrate, the piezoelectric-body film joint substrate with no residual stress distortion can be manufactured.

Further, since the PZT film 15 being monocrystalline has a higher piezoelectric constant compared to a polycrystalline PZT film, amplitude of the oscillation can be increased with ease. Furthermore, since the AlN film 25 being monocrystalline has lower specific inductive capacity compared to a polycrystalline AlN film, the oscillation reception sensitivity can be increased. However, the PZT film 15 may contain polycrystalline PZT, and the AlN film 25 may contain polycrystalline AlN. Namely, monocrystallization ratios of the PZT film 15 and the AlN film 25 may be less than or equal to 100%.

Further, in the first embodiment, the height H2 of the top of the AlN piezoelectric-body film 27 is lower than the height H1 of the top of the PZT piezoelectric-body film 17, and thus a part of the stamp 42 such as a lower surface never makes contact with the AlN piezoelectric-body film 27 stuck on the Pt film 34b.

Moreover, conventionally, in order to form piezoelectric films of different types, a process like temporarily covering one piezoelectric film with a protective layer, forming the other piezoelectric film, and thereafter removing the protective layer used to be a complicated process, and application of heat in processing in each step used to leave residual stress distortion in the piezoelectric films and cause deterioration in the efficiency of the sensor. By the manufacturing method in the first embodiment, the piezoelectric-body film joint substrate and the acoustic oscillation sensor can be formed in the state with no residual stress distortion.

### (2) Second Embodiment

### (2-1) Structure of piezoelectric-body film Joint Substrate 200

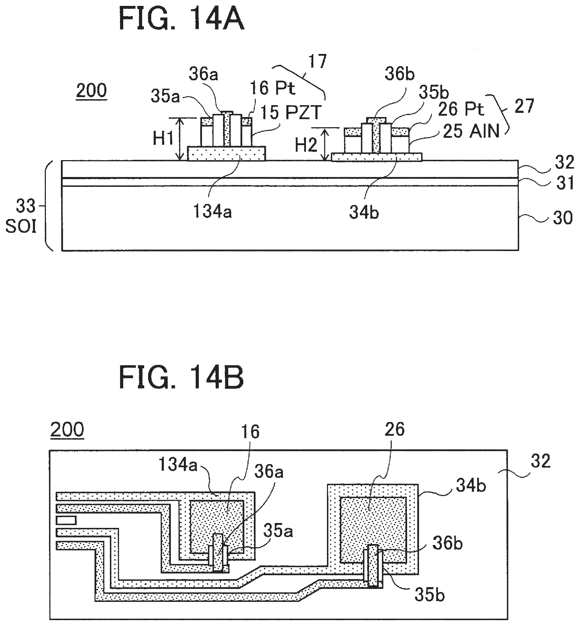

Figs. 14A and 14B are a side view and a top view schematically showing the structure of a piezoelectric-body film joint substrate 200 according to a second embodiment. In Figs. 14A and 14B, each component identical or corresponding to a component shown in Fig. 1 to Fig. 3 is assigned the same reference character as in Fig. 1 to Fig. 3.

The piezoelectric-body film joint substrate 200 includes a Pt film 134a as a substrate electrode provided on the SOI substrate 33, the PZT piezoelectric-body film 17 stuck on the Pt film 134a, the Pt film 34b as a substrate electrode provided on the SOI substrate 33, and the AlN piezoelectric-body film 27 stuck on the Pt film 34b. The PZT piezoelectric-body film 17 includes the PZT film 15 and the Pt film 16 formed on the PZT film 15, and the PZT film 15 is stuck on the Pt film 134a. The AlN piezoelectric-body film 27 includes the AlN film 25 and the Pt film 26 formed on the AlN film 25, and the AlN film 25 is stuck on the Pt film 34b. In the second embodiment, film thickness t134 of the Pt film 134a is set to be greater than film thickness t34 of the Pt film 34b. In the second embodiment, the height H1 from the upper surface of the SOI substrate 33, on which the Pt film 134a and the Pt film 34b are formed, to the top of the Pt film 16 and the height H2 from the upper surface of the SOI substrate 33 to the top of the Pt film 26 differ from each other. In the second embodiment, the relationship H1 > H2 is satisfied. Except for the above-described features, the structure of the piezoelectric-body film joint substrate 200 is the same as that of the piezoelectric-body film joint substrate 100.

### (2-2) Manufacturing Method

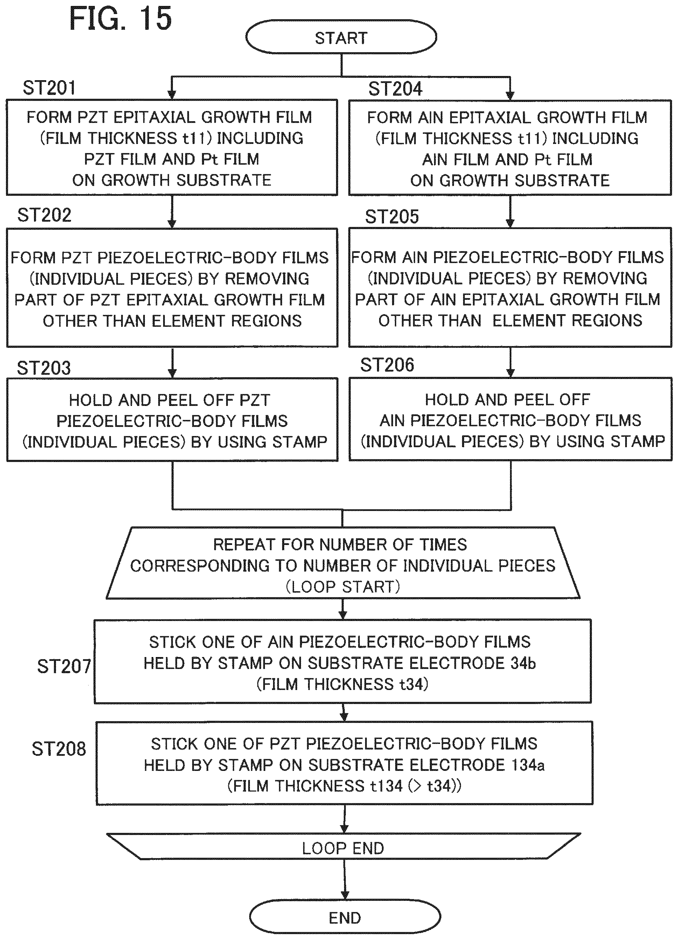

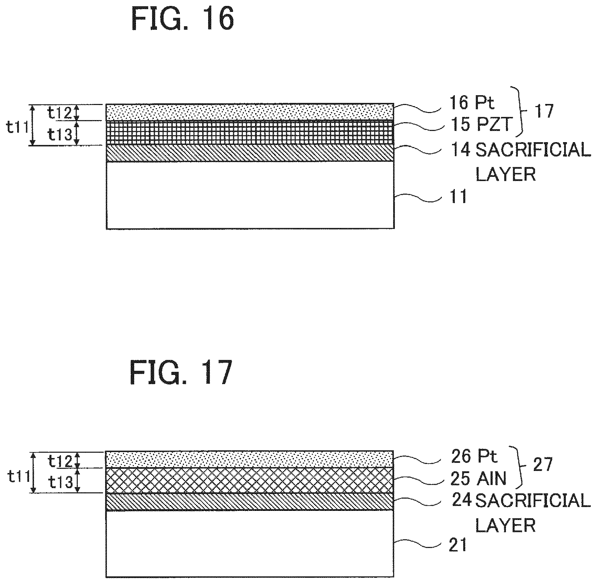

Fig. 15 is a flowchart showing a method of manufacturing the piezoelectric-body film joint substrate 200. Fig. 16 is a cross-sectional view schematically showing the structure of an epitaxial growth film including the PZT piezoelectric-body film 17. Fig. 17 is a cross-sectional view schematically showing the structure of an epitaxial growth film including the AlN piezoelectric-body film 27. As shown in Fig. 16 and Fig. 17, in the second embodiment, the thickness (t11 = t12 + t13) of the PZT piezoelectric-body film 17 and the thickness (t11 = t12 + t13) of the AlN piezoelectric-body film 27 being used are equal to each other. However, the height H1 from the upper surface of the SOI substrate 33 to the top of the Pt film 16 can be set higher than the height H2 from the upper surface of the SOI substrate 33 to the top of the Pt film 26 since the film thickness t134 of the Pt film 134a is set to be greater than the film thickness t34 of the Pt film 34b (namely, t134 > t34). Incidentally, the thickness of the PZT piezoelectric-body film 17 and the thickness of the AlN piezoelectric-body film 27 may also differ from each other within an extent in which the relationship H1 > H2 is satisfied.

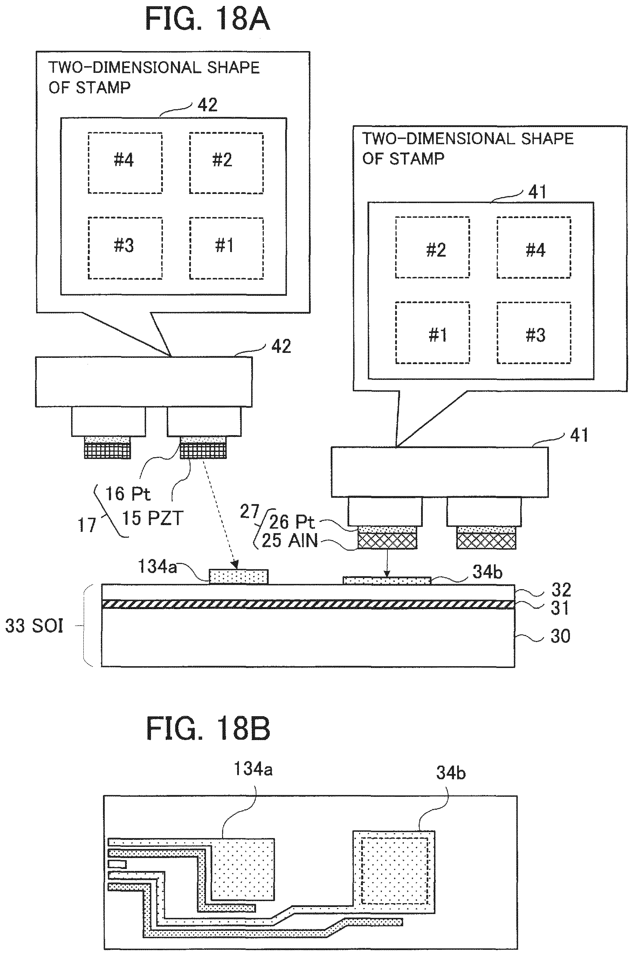

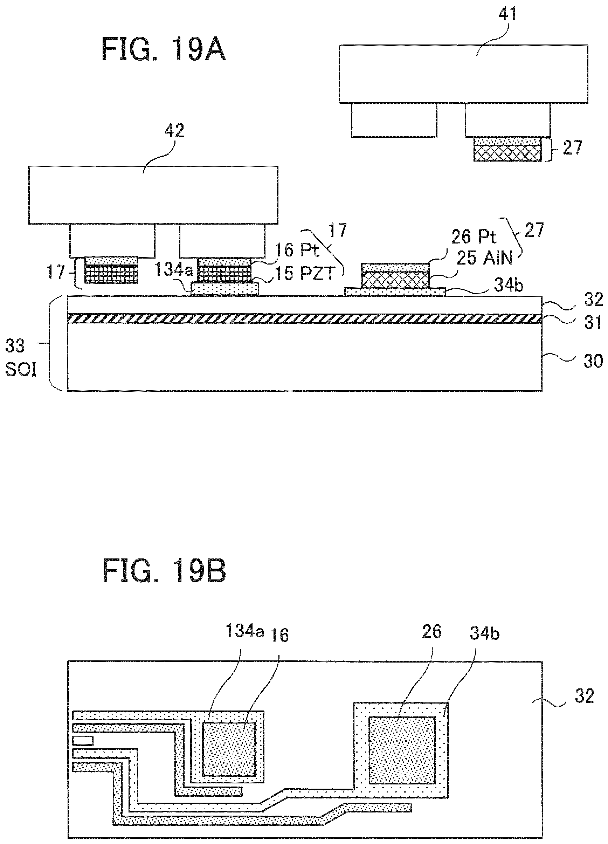

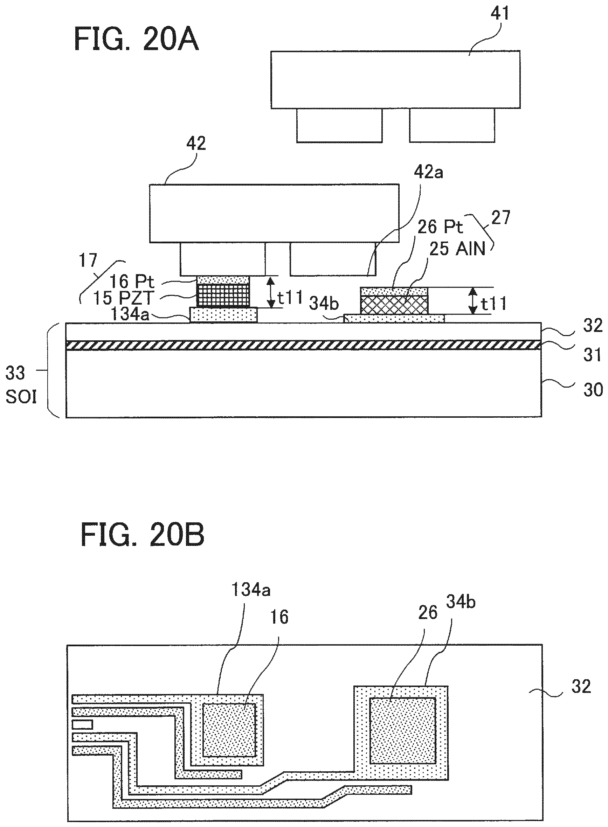

Fig. 18A shows a state in which the stamp 41 holds a plurality of AlN piezoelectric-body films 27 and the stamp 42 holds a plurality of PZT piezoelectric-body films, and Fig. 18B shows a state on the SOI substrate 33's side. Fig. 19A shows a state in which the AlN piezoelectric-body film 27 has been stuck on the Pt film 34b on the SOI substrate 33 and the stamp 42 holding the plurality of PZT piezoelectric-body films is sticking one PZT piezoelectric-body film on the Pt film 134a, and Fig. 19B shows a state on the SOI substrate 33's side. Fig. 20A shows a state in which the AlN piezoelectric-body film 27 has been stuck on the Pt film 34b on another SOI substrate and the stamp 42 holding the PZT piezoelectric-body films is sticking one PZT piezoelectric-body film on the Pt film 134a, and Fig. 20B shows a state on the SOI substrate 33's side.

In the manufacture of the piezoelectric-body film joint substrate 200, first, the sacrificial layer 14, the PZT film 15 and the Pt film 16 are grown epitaxially on a growth substrate as shown in Fig. 16 (step ST201), and a plurality of PZT piezoelectric-body films 17 are formed by forming the PZT film 15 and the Pt film 16 into desired shapes (e.g., quadrangular shapes) by removing part of the PZT film 15 and the Pt film 16 other than element regions by means of etching (step ST202).

Further, the sacrificial layer 24, the AlN film 25 and the Pt film 26 are grown epitaxially on another growth substrate as shown in Fig. 17 (step ST204), and a plurality of AlN piezoelectric-body films 27 are formed by forming the AlN film 25 and the Pt film 26 into desired shapes (e.g., quadrangular shapes) by removing part of the AlN film 25 and the Pt film 26 other than element regions by means of etching (step ST205).

Subsequently, a plurality of PZT piezoelectric-body films 17 as individual pieces each formed with the PZT film 15 and the Pt film 16 are held by the stamp 42 and are peeled off by etching the sacrificial layer (step ST203). Further, a plurality of AlN piezoelectric-body films 27 as individual pieces each formed with the AlN film 25 and the Pt film 26 are held by the stamp 41 and are peeled off by etching the sacrificial layer (step ST206).

Subsequently, as shown in Figs. 18A and 18B, one of the plurality of AlN piezoelectric-body films 27 held by the stamp 41 is stuck on the Pt film 34b being a substrate electrode (step ST207).

Subsequently, as shown in Figs. 19A and 19B, one of the plurality of PZT piezoelectric-body films 17 held by the stamp 42 is stuck on the Pt film 134a being a substrate electrode (step ST208).

Subsequently, the step ST207 and the step ST208 in Fig. 15 are repeated respectively for a number of times corresponding to the number of AlN piezoelectric-body films 27 held by the stamp 41 and a number of times corresponding to the number of PZT piezoelectric-body films 17 held by the stamp 42. Incidentally, the number of AlN piezoelectric-body films 27 held by the stamp 41 and the number of PZT piezoelectric-body films 17 held by the stamp 42 may be different numbers.

As shown in Figs. 18A and 18B, in the second embodiment, the contact electrodes and the wiring pattern are formed with Pt on the SOI substrate 33, the AlN piezoelectric-body film 27 is stuck on the Pt film 34b, and thereafter the PZT piezoelectric-body film 17 is stuck on the Pt film 134a. In cases where the AlN piezoelectric-body films 27 held by the stamp 41 are in a 2 x 2 matrix, the AlN piezoelectric-body films 27 are successively stuck on different SOI substrates 33 in the illustrated order of #1, #2, #3 and #4. In this example, four SOI substrates 33 are prepared for the four piezoelectric-body films. Subsequently, the PZT piezoelectric-body film 17 is stuck on the Pt film 134a as shown in Figs. 19A and 19B. In cases where the PZT piezoelectric-body films 17 held by the stamp 42 are in a 2 x 2 matrix, the PZT piezoelectric-body films 17 are successively stuck on different SOI substrates 33 in the illustrated order of #1, #2, #3 and #4. In this case, since the height H2 of the top of the AlN piezoelectric-body film 27 is lower than the height H1 of the top of the PZT piezoelectric-body film 17, the part 42a of the stamp 42 never makes contact with the AlN piezoelectric-body film 27 stuck on the Pt film 34b as shown in Fig. 20A.

Subsequently, the insulation film 35a and the wiring film 36a are formed on the PZT film 15 and the Pt film 16, and the insulation film 35b and the wiring film 36b are formed on the AlN film 25 and the Pt film 26.

### (2-3) Effect

As described above, in the second embodiment, the PZT piezoelectric-body film 17 and the AlN piezoelectric-body film 27 are respectively formed on separate growth substrates, peeled off from the growth substrates, and stuck on a common SOI substrate 33, by which a high-performance piezoelectric-body film joint substrate 200 can be made.

Further, in the second embodiment, the height H1 of the top of the PZT piezoelectric-body film 17 is higher than the height H2 of the top of the AlN piezoelectric-body film 27 due to the thickened Pt film 134a, and thus a part of the stamp 42 such as the lower surface never makes contact with the AlN piezoelectric-body film 27 stuck on the Pt film 34b.

Incidentally, except for the above-described features, the second embodiment is the same as the first embodiment.

### (3) Third Embodiment

### (3-1) Structure of piezoelectric-body film Joint Substrate 300

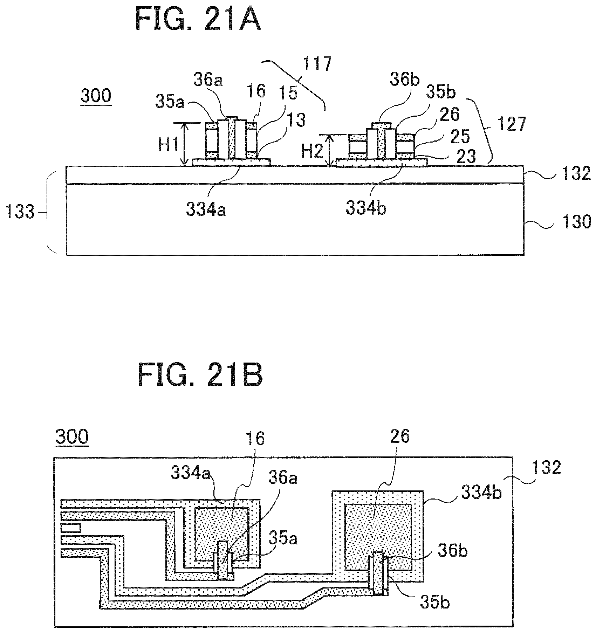

Figs. 21A and 21B are a side view and a top view schematically showing the structure of a piezoelectric-body film joint substrate 300 according to a third embodiment. In Figs. 21A and 21B, each component identical or corresponding to a component shown in Fig. 1 to Fig. 3 is assigned the same reference character as in Fig. 1 to Fig. 3.

The piezoelectric-body film joint substrate 300 includes a Pt film 334a as a substrate electrode provided on a glass polyimide multilayer substrate 133 as a substrate, a PZT piezoelectric-body film 117 as a first piezoelectric-body film stuck on the Pt film 334a, a Pt film 334b as a substrate electrode provided on the glass polyimide multilayer substrate 133 as a substrate, and an AlN piezoelectric-body film 127 as a second piezoelectric-body film stuck on the Pt film 334b. The PZT piezoelectric-body film 117 has structure as a stack of a Pt film 13, the PZT film 15 and the Pt film 16, and the Pt film 13 is stuck on the Pt film 334a. The AlN piezoelectric-body film 127 has structure as a stack of a Pt film 23, the AlN film 25 and the Pt film 26, and the Pt film 23 is stuck on the Pt film 334b. In the third embodiment, the height H1 from the upper surface of the glass polyimide multilayer substrate 133, on which the Pt film 334a and the Pt film 334b are formed, to the top of the Pt film 16 and the height H2 from the upper surface of the glass polyimide multilayer substrate 133 to the top of the Pt film 26 differ from each other. In the third embodiment, the relationship H1 > H2 is satisfied. Incidentally, the glass polyimide multilayer substrate 133 is formed with a glass part 130 and a polyimide part 132 overlaid on the glass part 130. Except for the above-described features, the structure of the piezoelectric-body film joint substrate 300 is the same as that of the piezoelectric-body film joint substrate 100 or 200. While the substrate electrodes are formed with Pt (platinum) in this example, it is not particularly necessary to limit the material of the substrate electrodes to Pt. For example, the substrate electrodes may be formed with a variety of metal such as gold, aluminum or copper.

### (3-2) Manufacturing Method

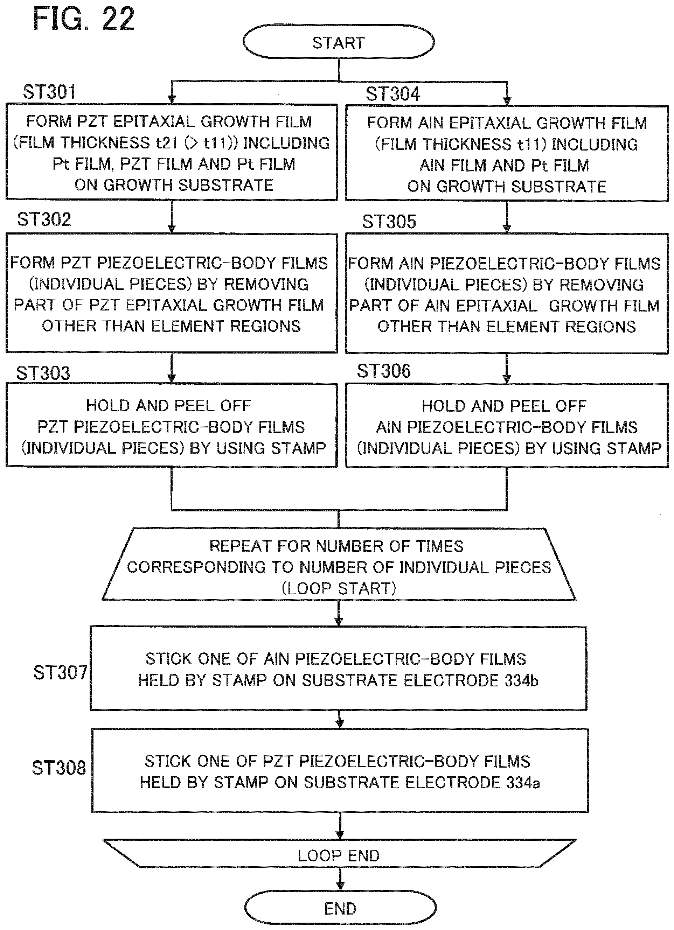

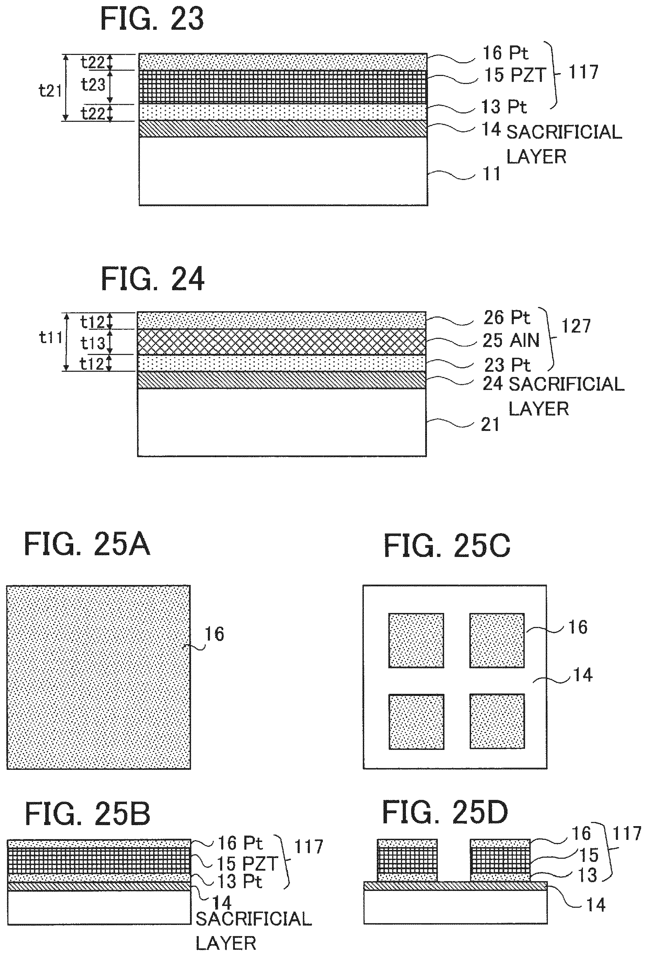

Fig. 22 is a flowchart showing a method of manufacturing the piezoelectric-body film joint substrate 300. Fig. 23 is a cross-sectional view schematically showing the structure of an epitaxial growth film including the PZT piezoelectric-body film 117. Fig. 24 is a cross-sectional view schematically showing the structure of an epitaxial growth film including the AlN piezoelectric-body film 127. As shown in Figs. 23 and 24, in the third embodiment, the thickness (t21 = t22 + t23 + t22) of the PZT piezoelectric-body film 117 and the thickness (t11 = t12 + t13 + t12) of the AlN piezoelectric-body film 127 have a relationship t21 > t11. With this relationship, the height H1 from the upper surface of the glass polyimide multilayer substrate 133 to the top of the Pt film 16 can be set higher than the height H2 from the upper surface of the glass polyimide multilayer substrate 133 to the top of the Pt film 26.

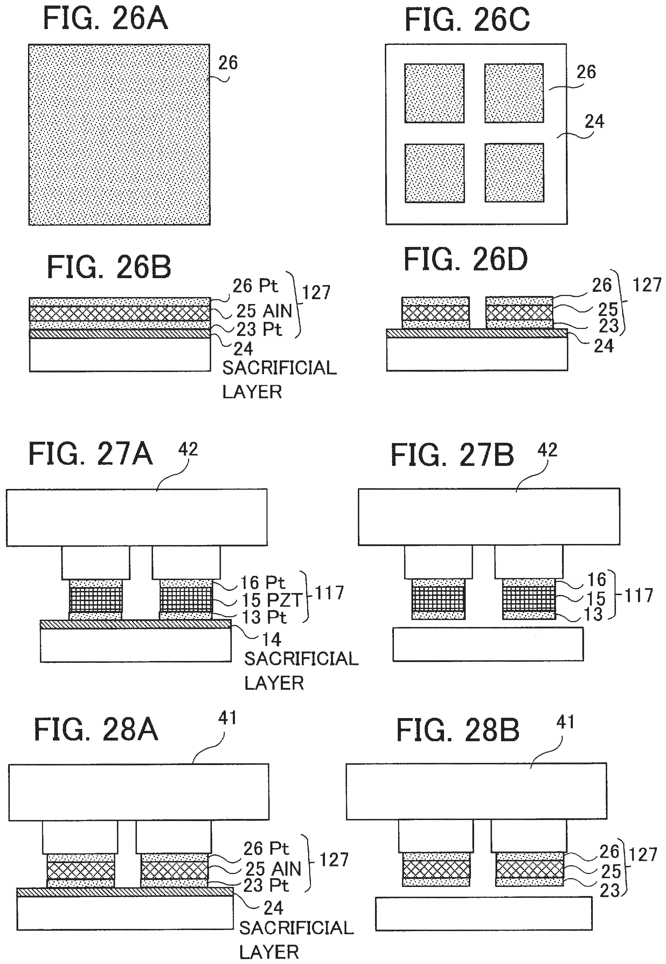

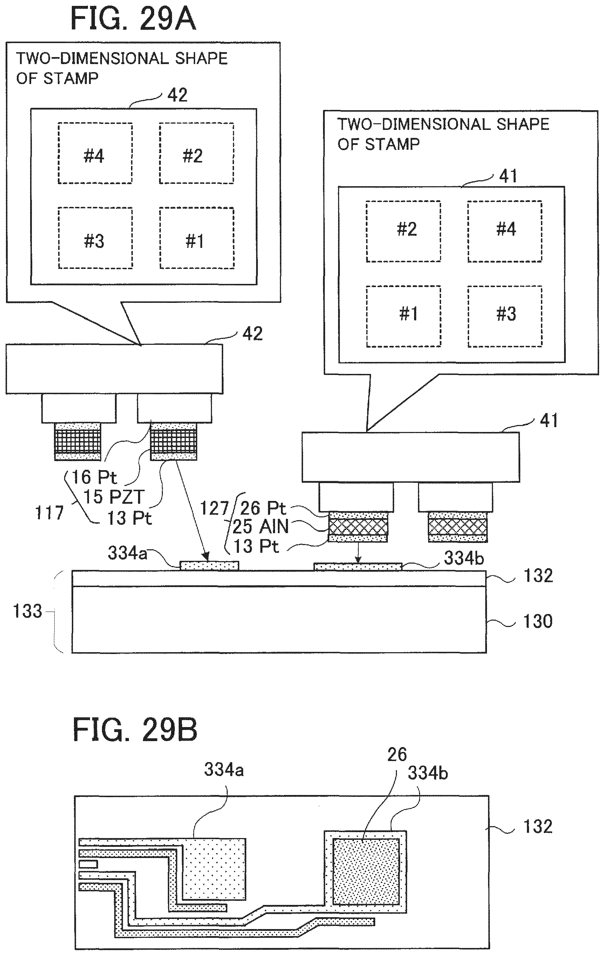

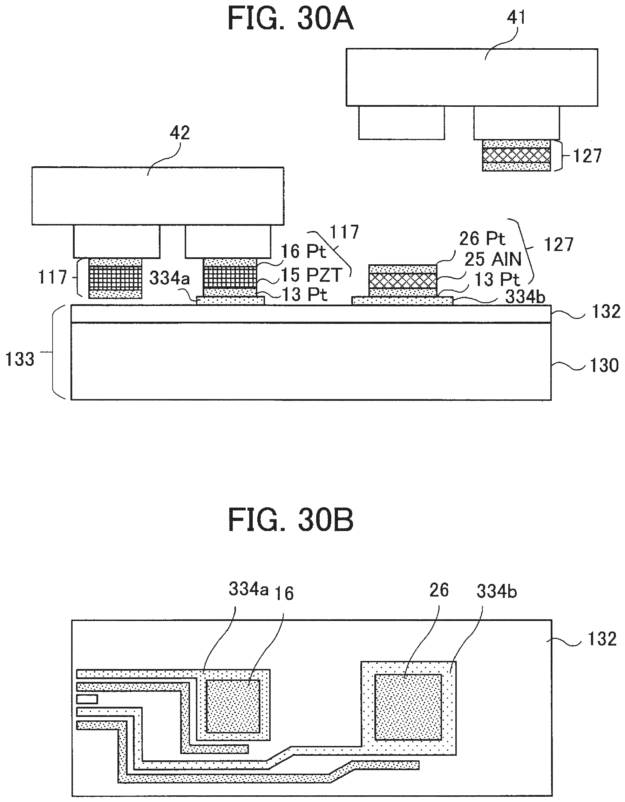

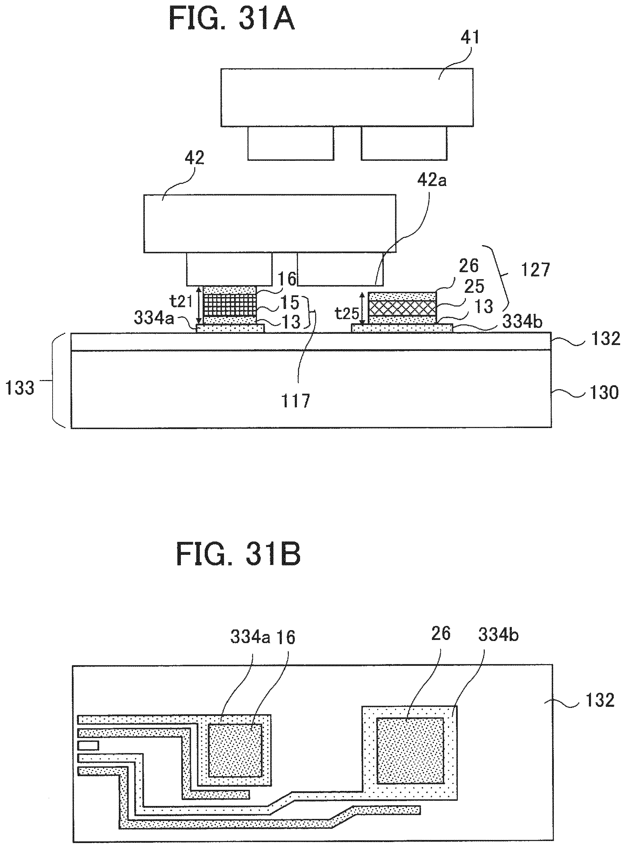

Figs. 25A and 25B are a top view and a cross-sectional view schematically showing the structure of the PZT epitaxial growth film in step ST301 in Fig. 22. Figs. 25C and 25D are a top view and a cross-sectional view schematically showing the structure of the PZT epitaxial growth film in step ST302 in Fig. 22. Figs. 26A and 26B are a top view and a cross-sectional view schematically showing the structure of the AlN epitaxial growth film in step ST304 in Fig. 22. Figs. 26C and 26D are a top view and a cross-sectional view schematically showing the structure of the AlN epitaxial growth film in step ST305 in Fig. 22. Figs. 27A and 27B are cross-sectional views schematically showing a holding process of a plurality of PZT piezoelectric-body films 117 in step ST303 in Fig. 22. Figs. 28A and 28B are cross-sectional views schematically showing a holding process of a plurality of AlN piezoelectric-body films 127 in step ST306 in Fig. 22. Fig. 29A is a cross-sectional view schematically showing a sticking process of the AlN piezoelectric-body film 127 in step ST307 in Fig. 22, and Fig. 29B is a top view showing a position where the AlN piezoelectric-body film 127 is stuck. Fig. 30A is a cross-sectional view schematically showing a sticking process of the PZT piezoelectric-body film 117 in step ST308 in Fig. 22, and Fig. 30B is a top view showing a state in which the PZT piezoelectric-body film 117 has been stuck. Fig. 31A is a cross-sectional view showing a manufacturing process of the next piezoelectric-body film joint substrate, and Fig. 31B is a top view showing a state in which the PZT piezoelectric-body film 117 has been stuck.

In the manufacture of the piezoelectric-body film joint substrate 300, first, the sacrificial layer 14, the Pt film 13, the PZT film 15 and the Pt film 16 are grown epitaxially on a growth substrate as shown in Fig. 23 (step ST301), and a plurality of PZT piezoelectric-body films 117 are formed by forming the Pt film 13, the PZT film 15 and the Pt film 16 into desired shapes (e.g., quadrangular shapes) by removing part of the Pt film 13, the PZT film 15 and the Pt film 16 other than element regions by means of etching (step ST302).

Further, the sacrificial layer 24, the Pt film 23, the AlN film 25 and the Pt film 26 are grown epitaxially on another growth substrate as shown in Fig. 24 (step ST304), and a plurality of AlN piezoelectric-body films 127 are formed by forming the AlN film 25 and the Pt film 26 into desired shapes (e.g., quadrangular shapes) by removing part of the AlN film 25 and the Pt film 26 other than element regions by means of etching (step ST305).

Subsequently, a plurality of PZT piezoelectric-body films 117 as individual pieces each formed with the Pt film 13, the PZT film 15 and the Pt film 16 are held by the stamp 42 and are peeled off by etching the sacrificial layer (step ST303). Further, a plurality of AlN piezoelectric-body films 127 as individual pieces each formed with the Pt film 23, the AlN film 25 and the Pt film 26 are held by the stamp 41 and are peeled off by etching the sacrificial layer (step ST306).

Subsequently, as shown in Figs. 29A and 29B, one of the plurality of AlN piezoelectric-body films 127 held by the stamp 41 is stuck on the Pt film 334b being a substrate electrode (step ST307).

Subsequently, as shown in Figs. 30A and 30B, one of the plurality of PZT piezoelectric-body films 117 held by the stamp 42 is stuck on the Pt film 334a being a substrate electrode (step ST308).

Subsequently, the step ST307 and the step ST308 in Fig. 22 are repeated respectively for a number of times corresponding to the number of AlN piezoelectric-body films 127 held by the stamp 41 and a number of times corresponding to the number of PZT piezoelectric-body films 117 held by the stamp 42. Incidentally, the number of AlN piezoelectric-body films 127 held by the stamp 41 and the number of PZT piezoelectric-body films 117 held by the stamp 42 may be different numbers.

As shown in Figs. 29A and 29B, in the third embodiment, the contact electrodes and the wiring pattern are formed with Pt on the glass polyimide multilayer substrate 133, the AlN piezoelectric-body film 127 is stuck on the Pt film 334b, and thereafter the PZT piezoelectric-body film 117 is stuck on the Pt film 334a. In cases where the AlN piezoelectric-body films 127 held by the stamp 41 are in a 2 x 2 matrix, the AlN piezoelectric-body films 127 are successively stuck on different glass polyimide multilayer substrates 133 in the illustrated order of #1, #2, #3 and #4. In this example, four glass polyimide multilayer substrates 133 are prepared for the four piezoelectric-body films. Subsequently, the PZT piezoelectric-body film 117 is stuck on the Pt film 334a as shown in Figs. 30A and 30B. In cases where the PZT piezoelectric-body films 117 held by the stamp 42 are in a 2 x 2 matrix, the PZT piezoelectric-body films 117 are successively stuck on different glass polyimide multilayer substrates 133 in the illustrated order of #1, #2, #3 and #4. In this case, since the height H2 of the top of the AlN piezoelectric-body film 127 is lower than the height H1 of the top of the PZT piezoelectric-body film 117, the part 42a of the lower surface of the stamp 42 never makes contact with the AlN piezoelectric-body film 127 stuck on the Pt film 334b as shown in Fig. 31A.

Subsequently, the insulation film 35a and the wiring film 36a are formed on the PZT film 15 and the Pt film 16, and the insulation film 35b and the wiring film 36b are formed on the AlN film 25 and the Pt film 26.

### (3-3) Effect

As described above, in the third embodiment, the PZT piezoelectric-body film 117 and the AlN piezoelectric-body film 127 are respectively grown epitaxially on separate growth substrates, peeled off from the growth substrates, and stuck on a common glass polyimide multilayer substrate 133, by which a high-performance piezoelectric-body film joint substrate 300 can be made.

Further, in the third embodiment, the height H1 of the top of the PZT piezoelectric-body film 117 is higher than the height H2 of the top of the AlN piezoelectric-body film 127, and thus a part of the stamp 42 such as the lower surface never makes contact with the AlN piezoelectric-body film 127 stuck on the Pt film 334b.

Furthermore, according to the manufacturing method in the third embodiment, the AlN piezoelectric film and the PZT piezoelectric film provided with their electrodes are stuck on the substrate electrodes, and thus the annealing process for stabilizing characteristics becomes necessary and a plurality of piezoelectric-body films differing in the crystal structure can be provided on a non-heat-resistant substrate such as the glass polyimide multilayer substrate 133.

Incidentally, except for the above-described features, the third embodiment is the same as the first or second embodiment.

### (4) Description of Reference Characters

13: Pt film (lower electrode film), 15: PZT film (piezoelectric film), 16: Pt film (upper electrode film), 17, 117: PZT piezoelectric-body film (piezoelectric-body film), 23: Pt film (lower electrode film), 25: AlN film (piezoelectric film), 26: Pt film (upper electrode film), 27, 127: AlN piezoelectric-body film (piezoelectric-body film), 33: SOI substrate (substrate), 34a, 134a: Pt film (substrate electrode), 34b: Pt film (substrate electrode), 41, 42: stamp (holding member), 100, 100a, 200, 300: piezoelectric-body film joint substrate, 133: glass polyimide multilayer substrate, 334a: Pt film substrate electrode), 334b: Pt film substrate electrode), t1, t21: film thickness of PZT piezoelectric-body film, t4, t25: film thickness of AlN piezoelectric-body film, t11: film thickness of PZT piezoelectric-body film or AlN piezoelectric-body film.

## Claims

1. A piezoelectric-body film joint substrate (100, 200, 300) comprising:
a substrate (33);
a first electrode (34a) provided on the substrate (33);
a first piezoelectric-body film (17) stuck on the first electrode (34a) and including a first piezoelectric film (15) and a first upper electrode film (16) formed on the first piezoelectric film (15);
a second electrode (34b) provided on the substrate (33); and
a second piezoelectric-body film (27) stuck on the second electrode (34b) and including a second piezoelectric film (25) different from the first piezoelectric film (15) and a second upper electrode film (26) formed on the second piezoelectric film (25),
wherein a height from an upper surface of the substrate (33), on which the first electrode (34a) and the second electrode (34b) are formed, to a top of the first upper electrode film (16) and a height from the upper surface of the substrate (33) to a top of the second upper electrode film (26) differ from each other.

2. The piezoelectric-body film joint substrate (100) according to claim 1, wherein film thickness of the first piezoelectric-body film (17) and film thickness of the second piezoelectric-body film (27) differ from each other.

3. The piezoelectric-body film joint substrate (100) according to claim 1 or 2, wherein film thickness of the first piezoelectric-body film (17) is greater than film thickness of the second piezoelectric-body film (27).

4. The piezoelectric-body film joint substrate (200) according to claim 1, wherein thickness of the first electrode (34a) and thickness of the second electrode (34b) differ from each other.

5. The piezoelectric-body film joint substrate (300) according to any one of claims 1 to 4, wherein the first piezoelectric-body film (17) further includes a first lower electrode film (13) formed on a surface of the first piezoelectric film (15) on a side opposite to the first upper electrode film (16).

6. The piezoelectric-body film joint substrate (300) according to any one of claims 1 to 5, wherein the second piezoelectric-body film (27) further includes a second lower electrode film (23) formed on a surface of the second piezoelectric film (25) on a side opposite to the second upper electrode film (26).

7. The piezoelectric-body film joint substrate (100, 200, 300) according to any one of claims 1 to 6, wherein the first piezoelectric film (15) is monocrystalline and the second piezoelectric film (25) is monocrystalline.

8. The piezoelectric-body film joint substrate (100, 200, 300) according to any one of claims 1 to 7, wherein
area of a surface of the first electrode (34a) is greater than area of a sticking surface of the first piezoelectric-body film (17) stuck on the surface of the first electrode (34a), and
area of a surface of the second electrode (34b) is greater than area of a sticking surface of the second piezoelectric-body film (27) stuck on the surface of the second electrode (34b).

9. The piezoelectric-body film joint substrate (100, 200, 300) according to any one of claims 1 to 8, wherein
the first piezoelectric film (15) is a PZT film, a KNN film or a barium titanate film, and
the second piezoelectric film (25) is an AlN film, a lithium tantalate film or a lithium niobate film.

10. A method of manufacturing a piezoelectric-body film joint substrate (100, 300) including a device substrate and a first piezoelectric-body film (17) and a second piezoelectric-body film (27) different from each other in film thickness, comprising:
peeling off the first piezoelectric-body film (17) formed on a first substrate and the second piezoelectric-body film (27) formed on a second substrate respectively from the first substrate and the second substrate;
sticking a film with first film thickness on a first electrode (34a) formed on the device substrate when one of the first piezoelectric-body film (17) and the second piezoelectric-body film (27), having less film thickness, is defined as the film with the first film thickness and the other one of the first piezoelectric-body film (17) and the second piezoelectric-body film (27), having greater film thickness, is defined as a film with second film thickness; and
sticking the film with the second film thickness on a second electrode (34b) formed on the device substrate after the sticking of the film with the first film thickness.

11. A method of manufacturing a piezoelectric-body film joint substrate (200) including a device substrate having a first electrode (34a) and a second electrode (34b) different from each other in film thickness, a first piezoelectric-body film (17), and a second piezoelectric-body film (27), the method comprising:
peeling off the first piezoelectric-body film (17) formed on a first substrate and the second piezoelectric-body film (27) formed on a second substrate respectively from the first substrate and the second substrate;
sticking the second piezoelectric-body film (27) on an electrode with second film thickness formed on the device substrate when one of the first electrode (34a) and the second electrode (34b), having greater film thickness, is defined as an electrode with first film thickness and the other one of the first electrode (34a) and the second electrode (34b), having less film thickness, is defined as the electrode with the second film thickness; and
sticking the first piezoelectric-body film (17) on the first electrode (34a) after the sticking of the film with the second film thickness.

12. The method of manufacturing a piezoelectric-body film joint substrate (100, 200) according to claim 10 or 11, wherein
the first piezoelectric-body film (17) includes a first piezoelectric film (15) and a first upper electrode film (16) formed on the first piezoelectric film (15), and
the second piezoelectric-body film (27) includes a second piezoelectric film (25) different from the first piezoelectric film (15) and a second upper electrode film (26) formed on the second piezoelectric film (25).

13. The method of manufacturing a piezoelectric-body film joint substrate (300) according to claim 12, wherein
the first piezoelectric-body film (17) further includes a first lower electrode film (13) formed on a surface of the first piezoelectric film (15) on a side opposite to the first upper electrode film (16), and
the second piezoelectric-body film (27) further includes a second lower electrode film (23) formed on a surface of the second piezoelectric film (25) on a side opposite to the second upper electrode film (26).

14. The method of manufacturing a piezoelectric-body film joint substrate (100, 200, 300) according to claim 12 or 13, wherein the first piezoelectric film (15) is monocrystalline and the second piezoelectric film (25) is monocrystalline.

15. The method of manufacturing a piezoelectric-body film joint substrate (100, 200, 300) according to any one of claims 10 to 14, wherein
area of a surface of the first electrode (34a) is greater than area of a sticking surface of the first piezoelectric-body film (17) to be stuck on the surface of the first electrode (34a), and
area of a surface of the second electrode (34b) is greater than area of a sticking surface of the second piezoelectric-body film (27) to be stuck on the surface of the second electrode (34b).
